# EUROPEAN PATENT APPLICATION

(11) **EP 4 745 968 A1**
(43) Date of publication of application: **20.05.2026**
(21) Application number: 25212647.9
(22) Date of filing: 31.10.2025
(51) Int. Cl.: G11C 7/10, G11C 7/22, G11C 8/12, G11C 8/18

(54) **MEMORY APPARATUS**

(30) Priority: 19.11.2024 KR 20240165087
(71) Applicant: SK hynix Inc., Bubal-eub Icheon-si Gyeonggi-do 17336 (KR)
(72) Inventor: PARK, Kyu Tae, 17336 Icheon-si, Gyeonggi-do (KR); PARK, Won Sun, 17336 Icheon-si, Gyeonggi-do (KR); LEE, Seung Nam, 17336 Icheon-si, Gyeonggi-do (KR)
(74) Representative: Isarpatent

(57) **Abstract**

A memory apparatus includes an instruction memory and a plurality of micro control units. The instruction memory outputs a plurality of instruction codes at a predetermined time interval in accordance with a plurality of address signals and a plurality of divided clock signals. The plurality of micro control units are coupled to each of a plurality of memory regions, provide each of the plurality of address signals to the instruction memory in accordance with each of the plurality of divided clock signals, and perform operations in accordance with corresponding instruction codes among the plurality of instruction codes.

## Description

### BACKGROUND

### 1.TECHNICAL FIELD

Various embodiments of the present disclosure generally relate to a semiconductor apparatus, and more particularly, to a memory apparatus sharing an instruction memory.

### 2. RELATED ART

A typical memory apparatus includes a plurality of memory regions, for example, a plurality of planes, a micro control unit for controlling the plurality of planes, and an instruction memory for storing instruction codes associated with the control operation. The memory apparatus supports a plane interleave read (PIR) mode for interleaving read operations over the plurality of planes.

However, due to the high integration of the typical memory apparatus, there are space limitations due to the arrangement and wiring for connections between the plurality of planes and the micro control unit and the instruction memory, and there is a concern of increased peak current due to the plane interleave read mode. In addition, there is a concern of increased area due to multiple instruction memories and a concern of decreased yield due to an increase in the probability of defects proportional to the number of instruction memories.

### SUMMARY

In an embodiment of the present disclosure, a memory apparatus may include an instruction memory and a plurality of micro control units. The instruction memory may output a plurality of instruction codes at a predetermined time interval in accordance with a plurality of address signals and a plurality of divided clock signals. The plurality of micro control units may be coupled to each of a plurality of memory regions, may provide each of the plurality of address signals to the instruction memory in accordance with each of the plurality of divided clock signals, and may perform operations in accordance with corresponding instruction codes among the plurality of instruction codes.

In an embodiment of the present disclosure, a memory apparatus may include a plurality of planes, an input/output pad circuit, a data input/output circuit, an instruction memory, and a plurality of memory operation control related circuits. The input/output pad circuit may include a plurality of pads. The data input/output circuit may be coupled with the input/output pad circuit. The instruction memory may output a plurality of instruction codes at a predetermined time interval in accordance with a plurality of address signals and a plurality of divided clock signals. The plurality of memory operation control related circuits may be in common connection with the data input/output circuit, may be in one-to-one connection with the plurality of planes, may provide each of the plurality of address signals to the instruction memory in accordance with each of the plurality of divided clock signals, and may perform operations in accordance with corresponding instruction codes among the plurality of instruction codes.

### BRIEF DESCRIPTION OF THE DRAWINGS

FIG. 1 is a diagram illustrating a configuration of a data storage device according to an embodiment of the present disclosure.
FIG. 2 is a diagram illustrating a configuration of a memory apparatus according to an embodiment of the present disclosure.
FIG. 3 is a diagram illustrating a configuration of a first plane and a peripheral circuit of FIG. 2.
FIG. 4 is a diagram illustrating a configuration of memory operation control related circuits of FIG. 2.
FIG. 5 is a diagram illustrating an operation of a memory apparatus according to an embodiment of the present disclosure.
FIG. 6 is a diagram illustrating a configuration of a memory apparatus according to an embodiment of the present disclosure.
FIG. 7 is a diagram illustrating a configuration of memory operation control related circuits of FIG. 6.
FIG. 8 is a diagram illustrating a configuration of a divider circuit of FIG. 6.
FIGS. 9 and 10 are diagrams illustrating an operation of the divider circuit of FIG. 8.
FIG. 11 is a diagram illustrating a configuration of an instruction memory of FIG. 6.
FIG. 12 is a diagram illustrating a configuration of a memory core of FIG. 11.
FIG. 13 is a diagram illustrating a configuration of an output control circuit of FIG. 11.
FIG. 14 is a diagram illustrating a configuration of a command output circuit of FIG. 11.
FIG. 15 is a diagram illustrating a configuration of a control signal generation circuit of FIG. 11.
FIGS. 16 and 17 are diagrams illustrating an operation of a control clock generation circuit of FIG. 15.
FIGS. 18 and 19 are diagrams illustrating an operation of a control signal generation unit of FIG. 15.
FIG. 20 is a diagram illustrating an operation of a memory apparatus according to an embodiment of the present disclosure.

### DETAILED DESCRIPTION

Various embodiments of the present disclosure can reduce circuit area and current consumption, and increase system efficiency and reliability.

Hereinafter, embodiments of the present disclosure will be described in more detail with reference to the accompanying drawings.

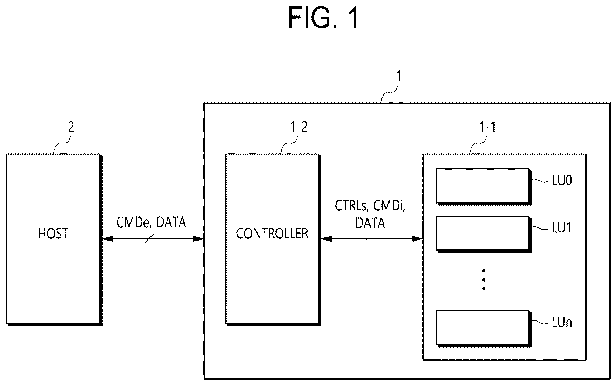

FIG. 1 is a diagram illustrating a configuration of a data storage device 1 according to an embodiment of the present disclosure.

Referring to FIG. 1, the data storage device 1 may be coupled with a host 2. The data storage device 1 may transmit/receive data DATA to/from the host 2 in response to a command (i.e., a request) CMDe received from the host 2. The data storage device 1 may include a memory apparatus 1-1 and a controller 1-2.

The memory apparatus 1-1 may include a plurality of logic units LU0 to LUn. A logic unit LU may be a unit for separating and managing the entire memory area of the data storage device 1. Each of the plurality of logic units LU0 to LUn may include at least one memory chip.

The controller 1-2 may generate and provide a plurality of control signals CRTLs and a command CMDi to the memory apparatus 1-1 in response to the command CMDe. The controller 1-2 may transmit/receive the data DATA to/from the memory apparatus 1-1 in accordance with a read operation and a write operation. The plurality of control signals CRTLs may include clock signals, signals related with activation of the memory chip, and signals related with the read operation and the write operation.

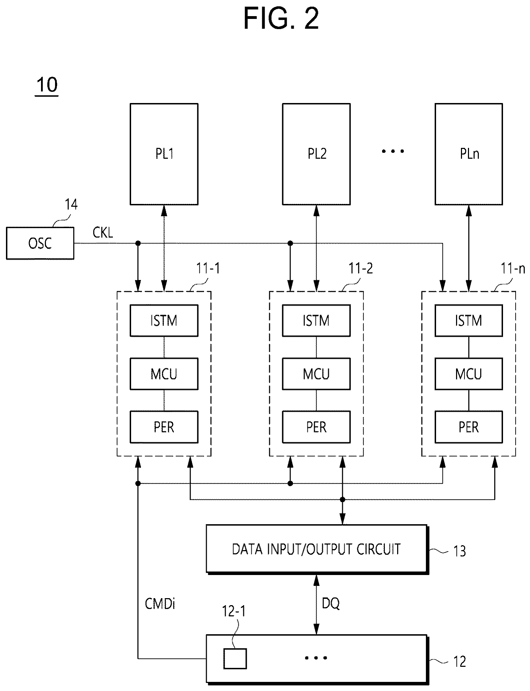

FIG. 2 is a diagram illustrating a configuration of a memory apparatus 10 according to an embodiment of the present disclosure.

Referring to FIG. 2, the memory apparatus 10 may include a plurality of memory regions, such as a plurality of planes PL1 to PLn, a plurality of memory operation control related circuits 11-1 to 11-n, an input/output pad circuit 12, a data input/output circuit 13 and a oscillator 14.

Each of the plurality of planes PL1 to PLn may include a memory cell array. A plurality of memory cells included in the memory cell array may include non-volatile memory cells.

The input/output pad circuit 12 may include a plurality of pads 12-1 for receiving the command CMDi, a clock signal CKL, and addresses, and for inputting and outputting data DQ.

The data input/output circuit 13 may be coupled in common between the plurality of memory operation control related circuits 11-1 to 11-n and the input/output pad circuit 12 to perform data input and output operations.

The oscillator 14 may generate the clock signal CKL.

The plurality of memory operation control related circuits 11-1 to 11-n may be coupled between the plurality of planes PL1 to PLn and the data input/output circuit 13. The plurality of memory operation control related circuits 11-1 to 11-n may be coupled one-to-one with the plurality of planes PL1 to PLn. For example, a first memory operation control related circuit 11-1 may be coupled between a first plane PL1 and the data input/output circuit 13, a second memory operation control related circuit 11-2 may be coupled between a second plane PL2 and the data input/output circuit 13, and an nth memory operation control related circuit 11-n may be coupled between an nth plane PLn and the data input/output circuit 13.

The plurality of memory operation control related circuits 11-1 to 11-n may be configured identically to each other. For example, the first memory operation control related circuit 11-1 may include an instruction memory ISTM, a micro control unit MCU, and a peripheral circuit PER. The instruction memory ISTM may store data related to an operation of the memory apparatus 10 (hereinafter, instruction data), and may output at least one instruction data corresponding to an external access as an instruction code among the stored instruction data. The instruction memory ISTM may be configured with a read-only memory (ROM).

The instruction data may include information directly related to an operation of the memory apparatus 10, i.e., information for instructing an operation of its circuit with respect to program/erase/read, etc. The instruction data may include information that is independent of data stored in the plurality of planes PL1 to PLn.

The peripheral circuit PER may include circuits related to data input and output of the first plane, such as circuit configurations for controlling program, read, and erase operations. The micro control unit MCU may control an operation of the peripheral circuit PER based on a result of decoding an instruction code provided from the instruction memory ISTM.

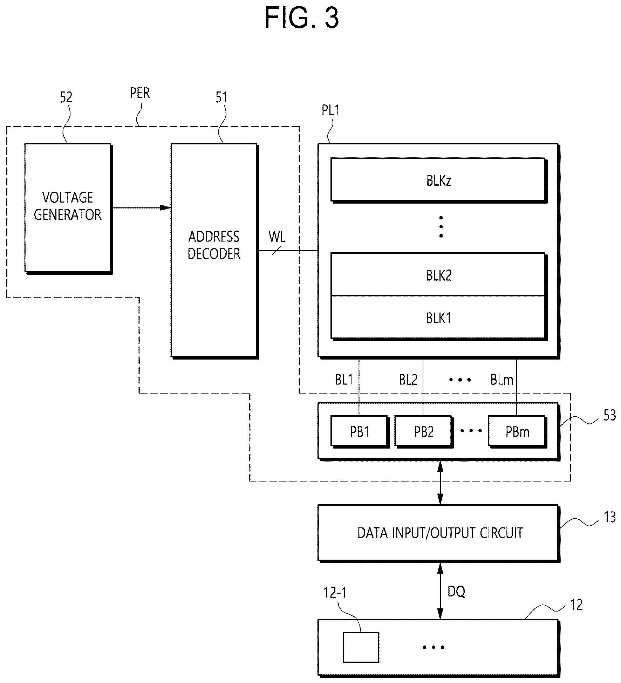

FIG. 3 is a diagram illustrating a configuration of the first plane PL1 and the peripheral circuit PER of FIG. 2.

Referring to FIG. 3, the peripheral circuit PER may include an address decoder (i.e., a row decoder) 51, a voltage generator 52, and a read and write circuit 53. The read and write circuit 53 may include a plurality of page buffers PB1 to PBm. The peripheral circuit PER is coupled to the first plane PL1 and may drive the first plane PL1 to perform a program operation, a read operation, and an erase operation.

The first plane PL1 may include a memory cell array and may be coupled to the address decoder 51 through wordlines WL and to the read and write circuit 53 through bitlines BL1 to BLm. The first plane PL1 may include a plurality of memory blocks BLK1 to BLKz. The plurality of memory blocks BLK1 to BLKz may be coupled to the address decoder 51 through the wordlines WL. The plurality of memory blocks BLK1 to BLKz may be coupled to the read and write circuit 53 through the bitlines BL1 to BLm. Each of the plurality of memory blocks BLK1 to BLKz may include a plurality of memory cells. The plurality of memory cells may be non-volatile memory cells. Each of the plurality of memory blocks BLK1 to BLKz may include a plurality of pages. Among the plurality of memory cells, memory cells coupled with the same wordline may be defined as a page.

The address decoder 51 may be coupled to the first plane PL1 through the wordlines WL. The address decoder 51 may select at least one memory block of the plurality of memory blocks BLK1 to BLKz based on a result of decoding an address provided by an external device (e.g., a host) to the memory apparatus 10. The address decoder 51 may select the at least one wordline of the selected memory block by applying a voltage generated from the voltage generator 52 to the at least one wordline WL of the selected memory block. The address decoder 51 may perform a program operation by applying a program voltage to the selected wordline and a pass voltage lower than the program voltage to non-selected wordlines. The address decoder 51 may perform a read operation by applying a read voltage to the selected wordline and a pass voltage higher than the read voltage to non-selected wordlines. The address decoder 51 may perform an erase operation by applying a ground voltage to wordlines coupled with the selected memory block and an erase voltage to a bulk region where the selected memory block is formed.

The voltage generator 52 may generate and provide to the address decoder 51 various voltages required for the operation of the memory apparatus 10, such as a read voltage, a pass voltage, a program voltage, and an erase voltage.

The plurality of page buffers PB1 to PBm may be coupled to the first plane PL1 through first to mth bitlines BL1 to BLm, respectively. The plurality of page buffers PB1 to PBm may be in data communication with the data input/output circuit 13.

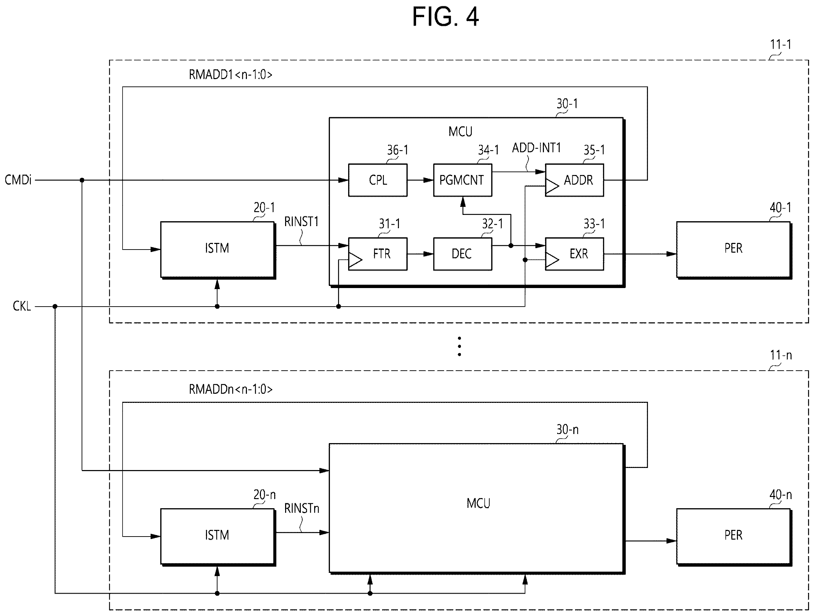

FIG. 4 is a diagram illustrating a configuration of the memory operation control related circuits 11-1 to 11-n of FIG. 2.

Referring to FIG. 4, the first memory operation control related circuit 11-1 coupled with the first plane PL1 may include an instruction memory (ISTM) 20-1, a micro control unit (MCU) 30-1, and a peripheral circuit (PER) 40-1.

The peripheral circuit 40-1 may include the configuration described with reference to FIG. 3. The peripheral circuit 40-1 may further include logic circuits for controlling the operation of the configuration described with reference to FIG. 3.

The instruction memory 20-1 may receive the clock signal CKL and an address signal RMADD1<n-1:0> and may output an instruction code RINST1. The instruction memory 20-1 may store instruction data related to various functions of the peripheral circuit 40-1. The instruction memory 20-1 may output instruction data corresponding to the address signal RMADD1<n-1:0> among a plurality of instruction data according to the clock signal CKL as the instruction code RINST1.

The micro control unit 30-1 may control the peripheral circuit 40-1 according to the clock signal CKL and the instruction code RINST1. The micro control unit 30-1 may include a fetch register (FTR) 31-1, a decoder (DEC) 32-1, an execution register (EXR) 33-1, a program counter (PGMCNT) 34-1, an address register (ADDR) 35-1, and a command processing logic (CPL) 36-1.

The fetch register 31-1 may store the instruction code RINST1 in response to the clock signal CKL. The decoder 32-1 may output a result of decoding the instruction code RINST1 stored in the fetch register 31-1. The execution register 33-1 may store an output of the decoder 32-1 and provide it to the peripheral circuit 40-1 according to the clock signal CKL. Based on an output of the execution register 33-1, the logic circuits of the peripheral circuit 40-1 may be selectively controlled. The program counter 34-1 may change a value of an internal address ADD-INT1 according to the output of the decoder 32-1. The address register 35-1 may store the internal address ADD-INT1 changed by the program counter 34-1 as the address signal RMADD1<n-1:0> according to the clock signal CKL and provide it to the instruction memory 20-1. The command processing logic 36-1 may control the program counter 34-1 in response to the command CMDi.

The nth memory operation control related circuit 11-n coupled with the nth plane PLn may include an instruction memory 20-n, a micro control unit (MCU) 30-n, and a peripheral circuit (PER) 40-n.

The peripheral circuit 40-n may be configured similarly to the peripheral circuit 40-1.

The instruction memory 20-n may receive the clock signal CKL and an address signal RMADDn<n-1:0> and output an instruction code RINSTn. The instruction memory 20-n may store the same instruction data as the instruction memory 20-1, and may output instruction data corresponding to the address signal RMADDn<n-1:0> as the instruction code RINSTn according to the clock signal CKL. The instruction memory 20-n may be configured similarly to the instruction memory 20-1.

The micro control unit 30-n may control the peripheral circuit 40-n according to the clock signal CKL and the instruction code RINSTn. The micro control unit 30-n may have the same configuration as the micro control unit 30-1.

FIG. 4 illustrates only a part of the memory operation control related circuits 11-1 to 11-n, and the memory operation control related circuits 11-1 to 11-n may be configured identically to each other.

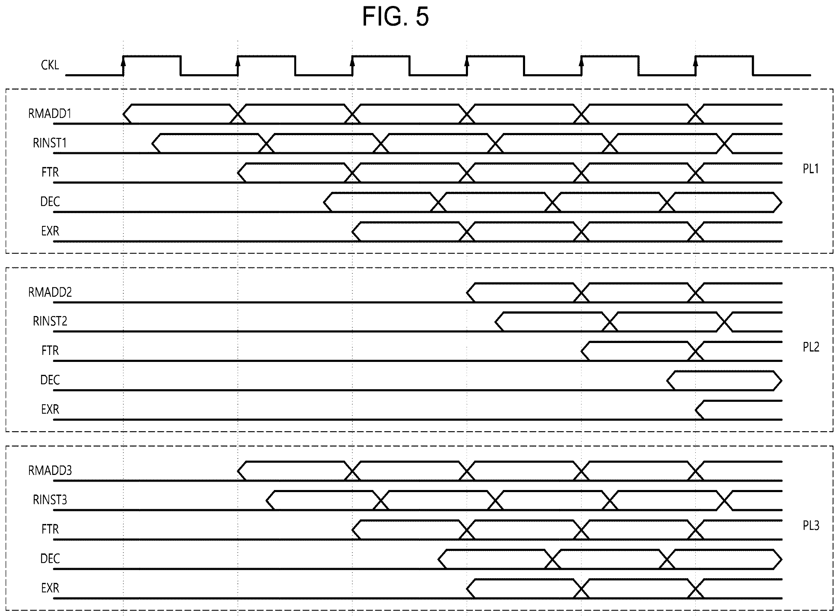

FIG. 5 is a diagram illustrating an operation of the memory apparatus 10 according to an embodiment of the present disclosure.

The memory apparatus 10 supports a plane interleave read (PIR) mode. The plane interleave read mode is an operation mode that causes a plurality of planes to perform read operations at defined time intervals.

For ease of description, the plurality of planes PL1 to PLn is three (n=3), and a plane interleave read operation of the memory apparatus 10 will be described.

Among the first to the third plane PL1 to PL3, the first plane PL1 is sequentially provided with differently valued address signal RMADD1 based on rising edge of the clock signal CKL.

The instruction codes RINST1 of different values are sequentially generated according to the address signals RMADD1 of different values.

The instruction codes RINST1 of different values are stored in the fetch register FTR with an interval of 1tCK relative to the input timing of the address signal RMADD1. 1tCK means one cycle time of the clock signal CKL.

The instruction codes RINST1 of different values are decoded sequentially by the decoder DEC.

An output of the decoder DEC is stored in the execution register 33-1 and provided to the peripheral circuit 40-1 with an interval of 1tCK relative to the input timing of the fetch register FTR.

The third plane PL3 may perform the same operation as the first plane PL1 with an interval of 1tCK relative to the first plane PL1.

The second plane PL2 may perform the same operation as the third plane PL3 with an interval of 2tCK relative to the third plane PL3.

The sequence of operations and/or time intervals of operations between each plane is by way of example only, and may change depending on the design and operation.

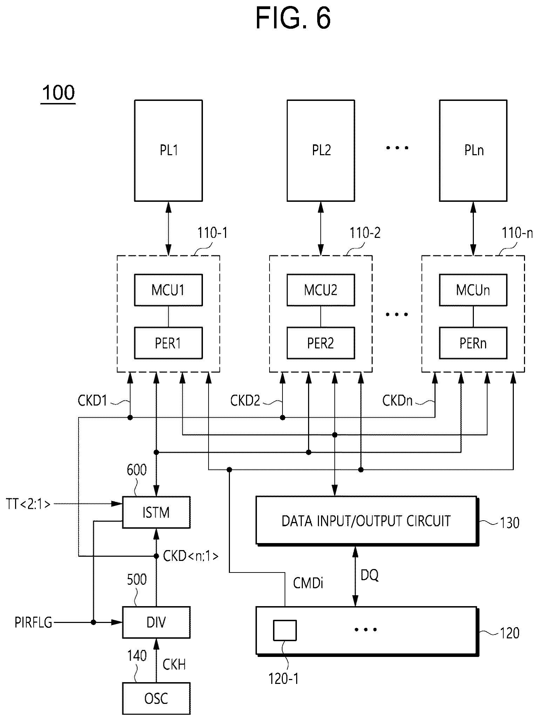

FIG. 6 is a diagram illustrating a configuration of a memory apparatus 100 according to an embodiment of the present disclosure.

Referring to FIG. 6, the memory apparatus 100 may include a plurality of planes PL1 to PLn, a plurality of memory operation control related circuits 110-1 to 110-n, an input/output pad circuit 120, a data input/output circuit 130, an oscillator (OSC) 140, a divider circuit (DIV) 500, and an instruction memory (ISTM) 600.

Each of the plurality of planes PL1 to PLn may include a memory cell array. A plurality of memory cells included in the memory cell array may include non-volatile memory cells.

The input/output pad circuit 120 may include a plurality of pads 120-1 for receiving the command CMDi, and for inputting and outputting data DQ.

The data input/output circuit 130 may be coupled in common between the plurality of memory operation control related circuits 110-1 to 110-n and the input/output pad circuit 120 to perform data input and output operations.

The plurality of memory operation control related circuits 110-1 to 110-n may be coupled between the plurality of planes PL1 to PLn and the data input/output circuit 130. The plurality of memory operation control related circuits 110-1 to 110-n may control operations related to data input and output of the plurality of planes PL1 to PLn, such as program/read/erase operations, etc. by controlling the plurality of planes PL1 to PLn. The plurality of memory operation control related circuits 110-1 to 110-n may be coupled one-to-one with the plurality of planes PL1 to PLn, and may be coupled in common with the data input/output circuit 130. A first memory operation control related circuit 110-1 may be coupled between a first plane PL1 and the data input/output circuit 130, a second memory operation control related circuit 110-2 may be coupled between a second plane PL2 and the data input/output circuit 130, and an nth memory operation control related circuit 110-n may be coupled between an nth plane PLn and the data input/output circuit 130.

The plurality of memory operation control related circuits 110-1 to 110-n may be configured identically to each other. The first memory operation control related circuit 110-1 may include a micro control unit MCU1 and a peripheral circuit PER1. The peripheral circuit PER1 may include data input and output related circuits of the first plane PL1, i.e., circuit configurations for controlling program, read, and erase operations. The micro control unit MCU1 may control an operation of the peripheral circuit PER1 based on a result of decoding an instruction code provided by the instruction memory 600. The second memory operation control related circuit 110-2 may include a micro control unit MCU2 and a peripheral circuit PER2, and the nth memory operation control related circuit 110-n may include a micro control unit MCUn and a peripheral circuit PERn.

The divider circuit 500 may receive a clock signal CKH and a plane interleave read mode setting signal PIRFLG and generate a plurality of divided clock signals CKD<n:1>. The divider circuit 500 may divide the clock signal CKH to generate a plurality of divided clock signals CKD<n:1>. The divider circuit 500 may adjust phases of the plurality of divided clock signals CKD<n:1> according to the plane interleave read mode setting signal PIRFLG.

The instruction memory 600 may receive the plurality of divided clock signals CKD<n:1>, the plane interleave read mode setting signal PIRFLG, a timing adjustment signal TT<2:1>, and a plurality of address signals and output a plurality of instruction codes. The instruction memory 600 may be shared by a plurality of micro control units MCU1 to MCUn. The instruction memory 600 may output the plurality of instruction codes at a predetermined time interval based on the plurality of divided clock signals CKD<n:1> according to the plane interleave read mode setting signal PIRFLG. The word "predetermined" as used herein with respect to a parameter, such as a predetermined timing, time, or voltage level, means that a value for the parameter is determined prior to the parameter being used in a process or algorithm. For some embodiments, the value for the parameter is determined before the process or algorithm begins. In other embodiments, the value for the parameter is determined during the process or algorithm but before the parameter is used in the process or algorithm.

The oscillator 140 may generate the clock signal CKH. The oscillator 140 may generate the clock signal CKH having a frequency corresponding to the number of the plurality of memory operation control related circuits 110-1 to 110-n, i.e., the number of the plurality of micro control units MCU1 to MCUn. For example, the oscillator 140 may generate the clock signal CKH with a frequency three times higher when the memory apparatus 100 includes three micro control units compared to when it includes only one micro control unit. In another example, the oscillator 140 may generate the clock signal CKH with a frequency four times higher when the memory apparatus 100 includes four micro control units compared to when it includes only one micro control unit. When the memory apparatus 100 includes only one micro control unit, a frequency of the clock signal CKH may be the same as a frequency of the clock signal CKL used in the memory apparatus 10 described with reference to FIG. 2. When the memory apparatus 100 includes three micro control units, a frequency of the clock signal CKH may be three times a frequency of the clock signal CKL used in the memory apparatus 10 described with reference to FIG. 2.

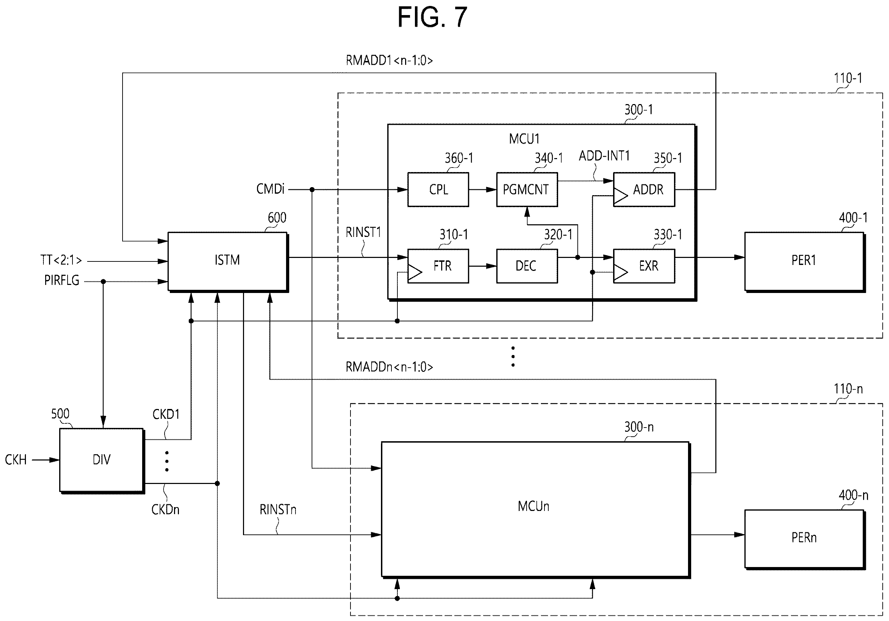

FIG. 7 is a diagram illustrating a configuration of the memory operation control related circuits 110-1 to 110-n of FIG. 6.

Referring to FIG. 7, the instruction memory 600 may receive the plurality of divided clock signals CKD<n:1>, the plane interleave read mode setting signal PIRFLG, the timing adjustment signal TT<2:1>, and a plurality of address signals RMADD<n:1><n-1:0> and output a plurality of instruction codes RINST<n:1>. The instruction memory 600 may store instruction data related to an operation of the memory apparatus 100.

The instruction data may include information directly related to an operation of the memory apparatus 100, i.e., information for instructing an operation of a corresponding circuit with respect to program/erase/read, etc. The instruction data may include information that is independent of the data stored in the plurality of planes PL1 to PLn.

The instruction memory 600 may output instruction data corresponding to the plurality of address signals RMADD<n:1><n-1:0> as a plurality of instruction codes RINST<n:1> from the stored instruction data. The instruction memory 600 may provide each of the plurality of instruction codes RINST<n:1> to each of the plurality of micro control units MCU1 to MCUn at a predetermined time interval in response to each of the plurality of divided clock signals CKD<n:1>.

The first memory operation control related circuit 110-1 coupled with the first plane PL1 may include a micro control unit (MCU1) 300-1 and a peripheral circuit (PER1) 400-1.

The peripheral circuit 400-1 may include the configuration described with reference to FIG. 3. The peripheral circuit 400-1 may further include logic circuits for controlling the operation of the configuration described with reference to FIG. 3.

The micro control unit 300-1 may receive a first instruction code RINST1 of the plurality of instruction codes RINST<n:1>, a first divided clock signal CKD1 of the plurality of divided clock signals CKD<n:1>, output a first address signal RMADD1<n-1:0> of the plurality of address signals RMADD<n:1><n-1:0>, and control the peripheral circuit 400-1.

The micro control unit 300-1 may include a fetch register (FTR) 310-1, a decoder (DEC) 320-1, an execution register (EXR) 330-1, a program counter (PGMCNT) 340-1, an address register (ADDR) 350-1, and command processing logic (CPL) 360-1.

The fetch register 310-1 may store the first instruction code RINST1 according to the first divided clock signal CKD1. The decoder 320-1 may output a result of decoding the first instruction code RINST1 stored in the fetch register 310-1. The execution register 330-1 may store and provide an output of the decoder 320-1 to the peripheral circuit 400-1 according to the first divided clock signal CKD1. Based on an output of the execution register 330-1, the logic circuits in the peripheral circuit 400-1 may be selectively controlled. The program counter 340-1 may change a value of an internal address ADD-INT1 in response to the output of the decoder 320-1. The address register 350-1 may store the internal address ADD-INT1 changed by the program counter 340-1 as the first address signal RMADD1<n-1:0> according to the first divided clock signal CKD1 and provide it to the instruction memory 600. The command processing logic 360-1 may control the program counter 340-1 in response to the command CMDi.

The nth memory operation control related circuit 110-n coupled with the nth plane PLn may include a micro control unit (MCUn) 300-n and a peripheral circuit (PERn) 400-n.

The peripheral circuit 400-n may have the same configuration as the peripheral circuit 400-1.

The micro control unit 300-n may receive an nth instruction code RINSTn of the plurality of instruction codes RINST<n:1>, an nth divided clock signal CKDn of the plurality of divided clock signals CKD<n:1>, output an nth address signal RMADDn<n-1:0> of the plurality of address signals RMADD<n:1><n-1:0>, and control the peripheral circuit 400-n. The micro control unit 300-n may have the same configuration as the micro control unit 300-1.

FIG. 7 illustrates only a part of the memory operation control related circuits 110-1 to 110-n, and the memory operation control related circuits 110-1 to 110-n may be configured identically to each other.

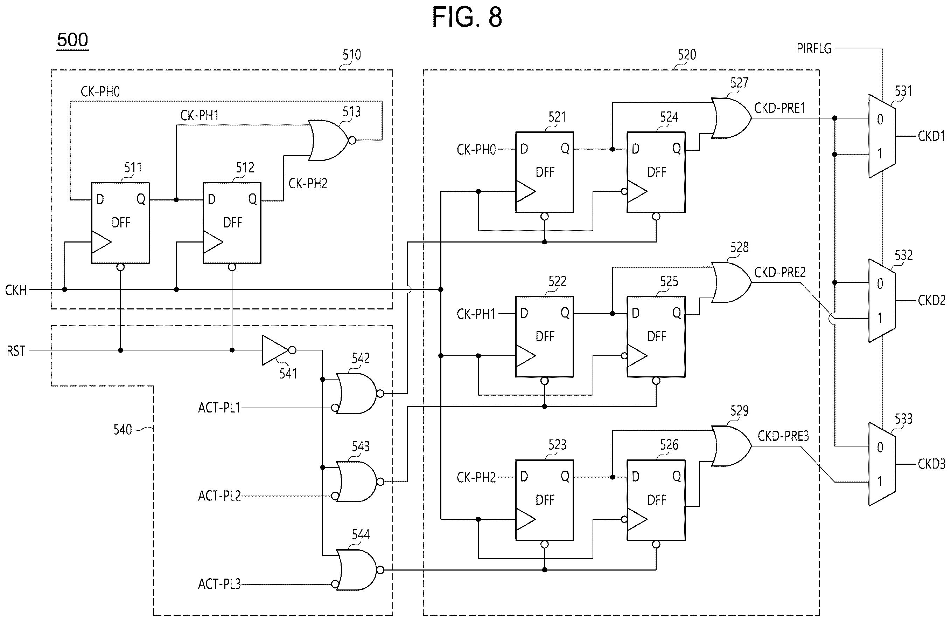

FIG. 8 is a diagram illustrating a configuration of the divider circuit 500 of FIG. 6, and FIGS. 9 and 10 are diagrams illustrating an operation of the divider circuit 500 of FIG. 8. FIG. 8 illustrates an example in which the memory apparatus 100 includes three planes PL1 to PL3 and three memory operation control related circuits 110-1 to 110-3, and the divider circuit 500 is configured to generate first to third divided clock signals CKD<3:1> accordingly.

Hereinafter, a configuration and an operation of the divider circuit 500 will be described with reference to FIG. 8 to FIG. 10.

In the following description, activation/deactivation of a circuit configuration means that the circuit configuration is in an operable/inoperable state, and activation/deactivation of a signal means that a logic level of the signal is at high/low or low/high.

Referring to FIG. 8, the divider circuit 500 may include a multi-phase signal generator 510, a pre-divided clock generator 520, an activation control circuit 540, and a plurality of multiplexers 531 to 533.

The multi-phase signal generator 510 may receive a reset signal RST and the clock signal CKH as inputs and output multi-phase signals CK-PH0 to CK-PH2. The reset signal RST may be activated at a low level at a predetermined timing during an initial operation of the data storage device 1 and upon a request from the host 2, and may be deactivated at a high level during other operation intervals.

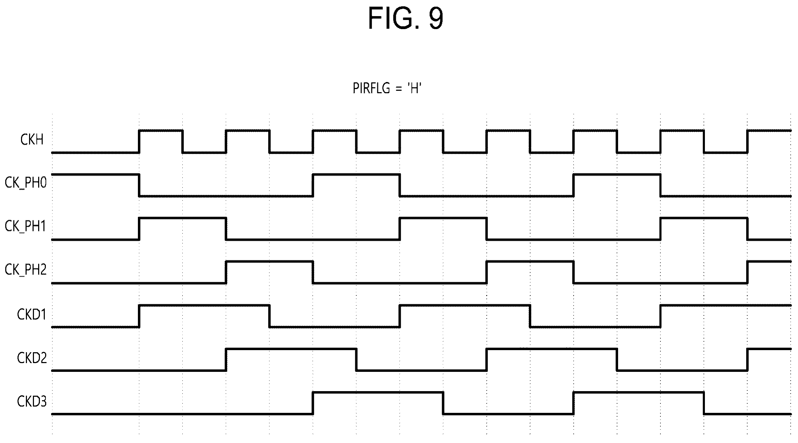

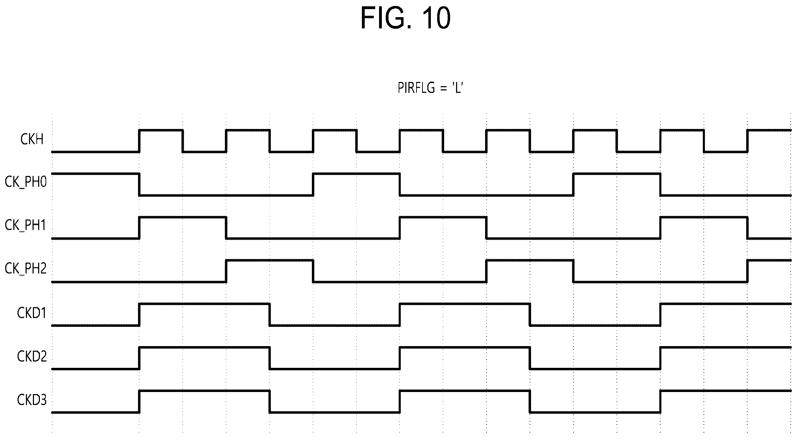

The multi-phase signal generator 510 may include a first flip-flop 511, a second flip-flop 512, and a logic gate 513. The first flip-flop 511 may output a first phase signal CK-PH0 latched to a rising edge of the clock signal CKH as a second phase signal CK-PH1. The second flip-flop 512 may output the second phase signal CK-PH1 latched to a rising edge of the clock signal CKH as a third phase signal CK-PH2. The logic gate 513 may output a result from performing a NOR operation on the second phase signal CK-PH1 and the third phase signal CK-PH2 as the first phase signal CK-PH0. The first flip-flop 511 and the second flip-flop 512 may be activated to perform the operations described above when the reset signal RST is at a high level, and may reset their outputs when the reset signal RST is at a low level. The multi-phase signals CK-PH0 to CK-PH2 may be generated with a predetermined phase difference as shown in FIGS. 9 and 10.

The pre-divided clock generator 520 may receive the multi-phase signals CK-PH0 to CK-PH2 and the clock signal CKH as inputs and output a plurality of pre-divided clock signals CKD-PRE1 to CKDPRE3. The pre-divided clock generator 520 may include first to sixth flip-flops 521 to 526 and first to third logic gates 527 to 529. The first flip-flop 521 may output a signal that latches the first phase signal CK-PH0 to a rising edge of the clock signal CKH. The second flip-flop 522 may output a signal that latches the second phase signal CK-PH1 to a rising edge of the clock signal CKH. The third flip-flop 523 may output a signal that latches the third phase signal CK-PH2 to a rising edge of the clock signal CKH. The fourth flip-flop 524 may output a signal that latches an output of the first flip-flop 521 to a falling edge of the clock signal CKH. The fifth flip-flop 525 may output a signal that latches an output of the second flip-flop 522 to a falling edge of the clock signal CKH. The sixth flip-flop 526 may output a signal that latches an output of the third flip-flop 523 to a falling edge of the clock signal CKH. The first logic gate 527 may output a result from performing an OR operation on the output of the first flip-flop 521 and an output of the fourth flip-flop 524 as a first pre-divided clock signal CKD-PRE1. The second logic gate 528 may output a result from performing an OR operation on the output of the second flip-flop 522 and an output of the fifth flip-flop 525 as a second pre-divided clock signal CKD-PRE2. The third logic gate 529 may output a result from performing an OR operation on the output of the third flip-flop 523 and an output of the sixth flip-flop 526 as a third pre-divided clock signal CKD-PRE3.

The activation control circuit 540 may selectively activate the pre-divided clock generator 520 in response to the reset signal RST and a plurality of active signals ACT-PL<3:1>. The activation control circuit 540 may include first to fourth logic gates 541 to 544. The first logic gate 541 may invert the reset signal RST and output an inverted reset signal. The second logic gate 542 may activate the flip-flops 521, 524 of the pre-divided clock generator 520 based on a result from performing a NOR operation on an output of the first logic gate 541 and an inverted first active signal ACT-PL1. The third logic gate 543 may activate the flip-flops 522, 525 of the pre-divided clock generator 520 based on a result from performing a NOR operation on an inverted second active signal ACT-PL2 and the output of the first logic gate 541. The fourth logic gate 544 may activate the flip-flops 523, 526 of the pre-divided clock generator 520 based on a result from performing a NOR operation on an inverted third active signal ACT-PL3 and the output of the first logic gate 541. The plurality of active signals ACT-PL<3:1> may be signals that are activated in response to a read command to the corresponding plane. The first active signal ACT-PL1 may be a signal that is activated by a read command for the first plane PL1, the second active signal ACT-PL2 may be a signal that is activated by a read command for the second plane PL2, and the third active signal ACT-PL3 may be a signal that is activated by a read command for the third plane PL3.

The plurality of multiplexers 531 to 533 may optionally output the plurality of pre-divided clock signals CKD-PRE1 to CKDPRE3 as the plurality of divided clock signals CKD<3:1> according to the plane interleave read mode setting signal PIRFLG. The plane interleave read mode setting signal PIRFLG may be activated when a read operation mode of the memory apparatus 100 is set to a plane interleave read mode, and deactivated otherwise. A first multiplexer 531 may output a first pre-divided clock signal CKD-PRE1 as a first divided clock signal CKD1 independent of the plane interleave read mode setting signal PIRFLG. A second multiplexer 532 may output the first pre-divided clock signal CKD-PRE1 as a second divided clock signal CKD2 when the plane interleave read mode setting signal PIRFLG is deactivated, and may output a second pre-divided clock signal CKD-PRE2 as the second divided clock signal CKD2 when the plane interleave read mode setting signal PIRFLG is activated. The third multiplexer 533 may output the first pre-divided clock signal CKD-PRE1 as a third divided clock signal CKD3 when the plane interleave read mode setting signal PIRFLG is deactivated, and may output a third pre-divided clock signal CKD-PRE3 as the third divided clock signal CKD3 when the plane interleave read mode setting signal PIRFLG is activated.

As shown in FIG. 9, when the plane interleave read mode setting signal PIRFLG is activated as the read operation mode of the memory apparatus 100 is set to the plane interleave read mode, the divider circuit 500 may generate the plurality of divided clock signals CKD<3:1> having a predetermined phase difference.

On the other hand, as shown in FIG. 10, when the plane interleave read mode setting signal PIRFLG is deactivated as the read operation mode of the memory apparatus 100 is set to a normal read mode, the divider circuit 500 may generate the plurality of divided clock signals CKD<3:1> having the same phase.

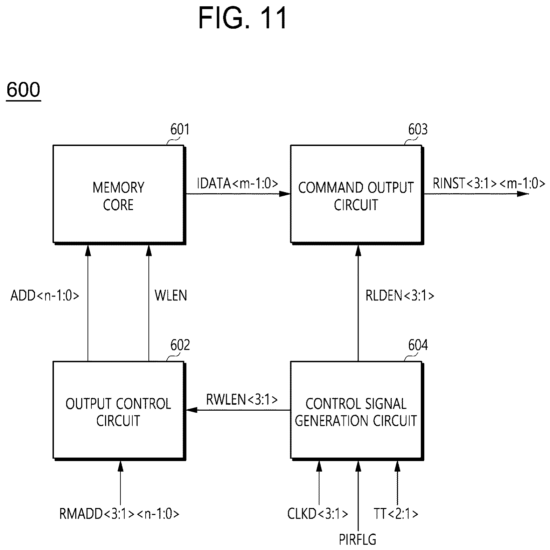

FIG. 11 is a diagram illustrating a configuration of the instruction memory 600 of FIG. 6.

Referring to FIG. 11, the instruction memory 600 may include a memory core 601, an output control circuit 602, a command output circuit 603, and a control signal generation circuit 604.

The memory core 601 may receive an integrated address signal ADD<n-1:0> and a wordline enable signal WLEN as input and may output instruction data IDATA<m-1:0>. The memory core 601 may output instruction data IDATA<m-1:0> corresponding to the integrated address signal ADD<n-1:0> among stored instruction data when the wordline enable signal WLEN is activated.

The output control circuit 602 may receive a plurality of address signals RMADD<3:1><n-1:0> and a plurality of preliminary wordline control signals RWLEN<3:1> as input and output the integrated address signal ADD<n-1:0> and the wordline enable signal WLEN.

The command output circuit 603 may receive the instruction data IDATA<m-1:0> and a plurality of load control signals RLDEN<3:1> and output a plurality of instruction codes RINST<3:1><m-1:0>.

The control signal generation circuit 604 may receive the plurality of divided clock signals CKD<3:1>, the plane interleave read mode setting signal PIRFLG, and the timing adjustment signal TT<2:1> and output the plurality of preliminary wordline control signals RWLEN<3:1> and the plurality of load control signals RLDEN<3:1>.

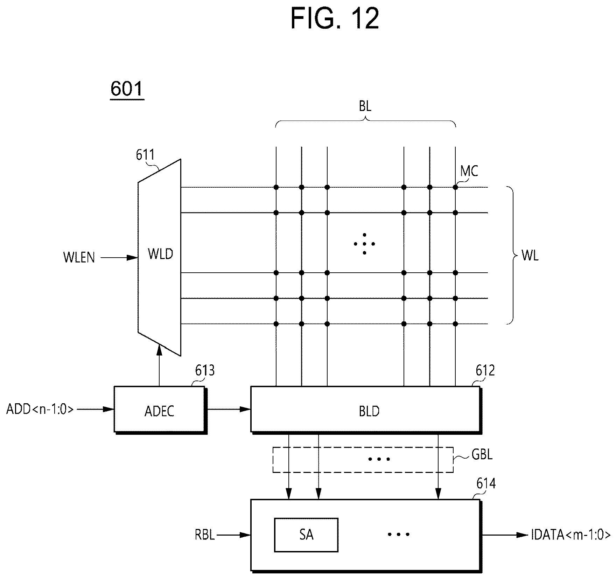

FIG. 12 is a diagram illustrating a configuration of the memory core 601 of FIG. 11.

Referring to FIG. 12, the memory core 601 may include a memory cell array, a wordline driver (WLD) 611, a bitline driver (BLD) 612, an address decoder (ADEC) 613, and a sense amplifier array 614.

The memory cell array may include memory cells MC coupled with a plurality of wordlines WL and a plurality of bitlines BL.

The address decoder 613 may output a result of decoding the integrated address signal ADD<n-1:0>.

The wordline driver 611 may activate a wordline corresponding to an output of the address decoder 613 among the plurality of wordlines WL when the wordline enable signal WLEN is activated.

The bitline driver 612 may be coupled between the plurality of bitlines BL and a global line GBL. The bitline driver 612 may transmit a signal on a bitline BL corresponding to an output of the address decoder 613 among the plurality of bitlines BL to the global line GBL.

The sense amplifier array 614 may include a plurality of sense amplifiers SA. The sense amplifier array 614 may amplify a result of comparing a level of the signal transmitted to the global line GBL with a reference signal RBL and output it as the instruction data IDATA<m-1:0>.

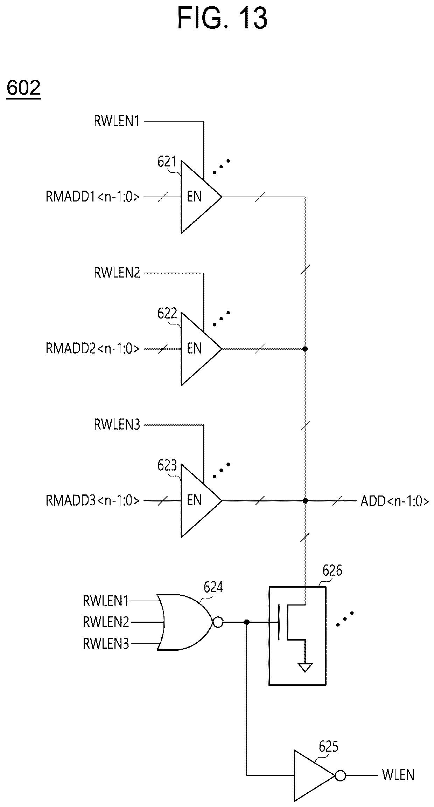

FIG. 13 is a diagram illustrating a configuration of the output control circuit 602 of FIG. 11.

Referring to FIG. 13, the output control circuit 602 may include a plurality of buffer arrays 621 to 623, first and second logic gates 624, 625, and a pull-down driver 626.

The first buffer array 621 may output a first address signal RMADD1<n-1:0> as the integrated address signal ADD<n-1:0> when a first preliminary wordline control signal RWLEN1 is activated. The first buffer array 621 may include as many buffers as the number of bits in the first address signal RMADD1<n-1:0>.

The second buffer array 622 may output a second address signal RMADD2<n-1:0> as the integrated address signal ADD<n-1:0> when a second preliminary wordline control signal RWLEN2 is activated. The second buffer array 622 may include as many buffers as the number of bits in the second address signal RMADD2<n-1:0>.

The third buffer array 623 may output a third address signal RMADD3<n-1:0> as the integrated address signal ADD<n-1:0> when a third preliminary wordline control signal RWLEN3 is activated. The third buffer array 623 may include as many buffers as the number of bits in the third address signal RMADD3<n-1:0>.

The first logic gate 624 may output a result from performing a NOR operation on the plurality of preliminary wordline control signals RWLEN<3:1>.

The second logic gate 625 may output a signal that inverts an output of the first logic gate 624 as the wordline enable signal WLEN.

The first logic gate 624 and the second logic gate 625 may activate the wordline enable signal WLEN when any of the plurality of preliminary wordline control signals RWLEN<3:1> is activated.

The pull-down driver 626 may initialize the integrated address signals ADD<n-1:0> based on the output of the first logic gate 624. The pull-down driver 626 may include as many drivers as the number of bits in the integrated address signal ADD<n-1:0>. The pull-down driver 626 may initialize the integrated address signal ADD<n-1:0> by pulling down outputs of the plurality of buffer arrays 621 to 623 to a ground voltage level.

The output control circuit 602 may initialize the integrated address signal ADD<n-1:0> when all of the plurality of preliminary wordline control signals RWLEN<3:1> are deactivated, and may generate the integrated address signal ADD<n-1:0> according to the plurality of address signals RMADD<3:1><n-1:0> when any of the plurality of preliminary wordline control signals RWLEN<3:1> is activated.

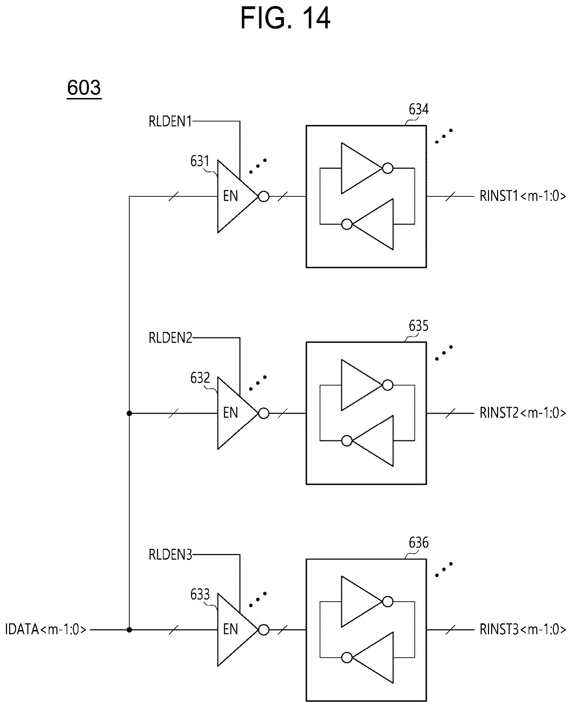

FIG. 14 is a diagram illustrating a configuration of the command output circuit 603 of FIG. 11.

Referring to FIG. 14, the command output circuit 603 may include a plurality of buffer arrays 631 to 633 and a plurality of latch arrays 634 to 636.

The first buffer array 631 may invert and output the instruction data IDATA<m-1:0> when a first load control signal RLDEN1 is activated. The first buffer array 631 may include as many buffers as the number of bits of the instruction data IDATA<m-1:0>.

The second buffer array 632 may invert and output the instruction data IDATA<m-1:0> when a second load control signal RLDEN2 is activated. The second buffer array 632 may include as many buffers as the number of bits of the instruction data IDATA<m-1:0>.

The third buffer array 633 may invert and output the instruction data IDATA<m-1:0> when a third load control signal RLDEN3 is activated. The third buffer array 633 may include as many buffers as the number of bits of the instruction data IDATA<m-1:0>.

The first latch array 634 may latch the output of the first buffer array 631 and output it as a first instruction code RINST1<m-1:0>. The first latch array 634 may include as many latches as the number of bits in the first instruction code RINST1<m-1:0>.

The second latch array 635 may latch the output of the second buffer array 632 and output it as a second instruction code RINST2<m-1:0>. The second latch array 635 may include as many latches as the number of bits in the second instruction code RINST2<m-1:0>.

The third latch array 636 may latch the output of the third buffer array 633 and output it as a third instruction code RINST3<m-1:0>. The third latch array 636 may include as many latches as the number of bits in the third instruction code RINST3<m-1:0>.

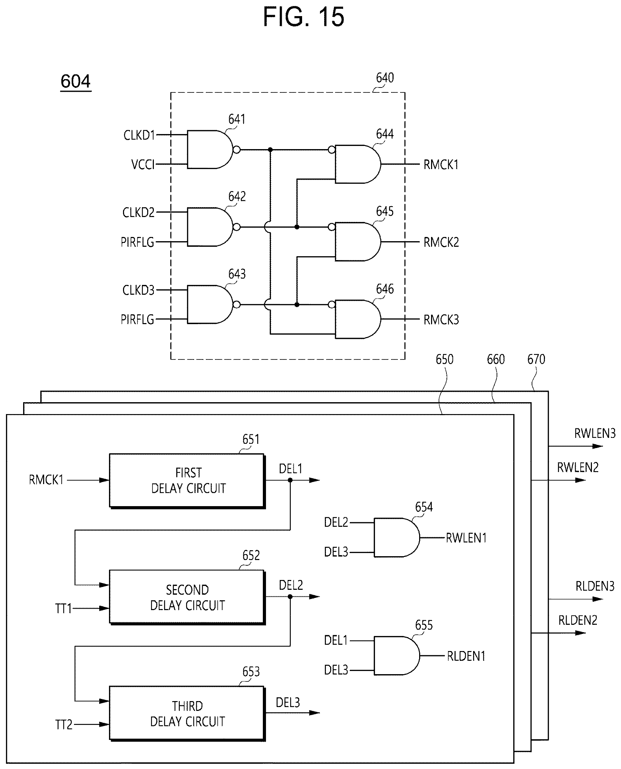

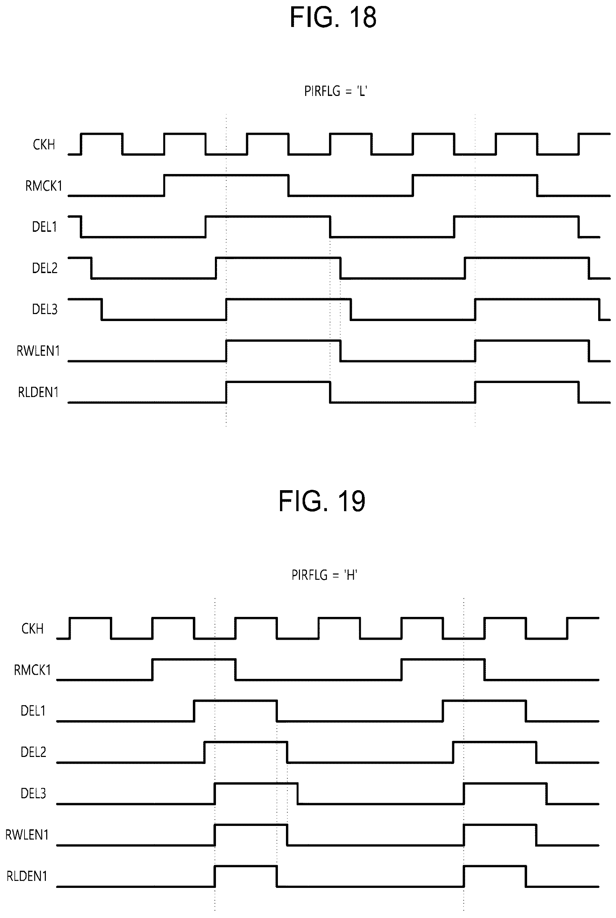

FIG. 15 is a diagram illustrating a configuration of the control signal generation circuit 604 of FIG. 11, FIGS. 16 and 17 are diagrams illustrating the operation of the control clock generation circuit 640 of FIG. 15, and FIGS. 18 and 19 are diagrams illustrating the operation of the control signal generation unit 650 of FIG. 15.

Hereinafter, the configuration and operation of the control signal generation circuit 604 will be described with reference to FIGS. 15 to 19.

Referring to FIG. 15, the control signal generation circuit 604 may include a control clock generation circuit 640 and a plurality of control signal generation units (i.e., control signal generation logics) 650 to 670.

The control clock generation circuit 640 may receive the plurality of divided clock signals CKD<3:1> and the plane interleave read mode setting signal PIRFLG as inputs and output a plurality of control clock signals RMCK<3:1>.

The control clock generation circuit 640 may include a plurality of logic gates 641 to 646. The first logic gate 641 may output a result from performing a NAND operation on the first divided clock signal CKD1 and a first supply voltage VCCI. The second logic gate 642 may output a result from performing a NAND operation on the second divided clock signal CKD2 and the plane interleave read mode setting signal PIRFLG. The third logic gate 643 may output a result from performing a NAND operation on the third divided clock signal CKD3 and the plane interleave read mode setting signal PIRFLG. The fourth logic gate 644 may output a result from performing a NAND operation on an inverted output of the first logic gate 641 and an output of the second logic gate 642 as a first control clock signal RMCK1. The fifth logic gate 645 may output a result from performing a NAND operation on an inverted output of the second logic gate 642 and an output of the third logic gate 643 as a second control clock signal RMCK2. The sixth logic gate 646 may output a result from performing a NAND operation on an inverted output of the third logic gate 643 and the output of the first logic gate 641 as a third control clock signal RMCK3.

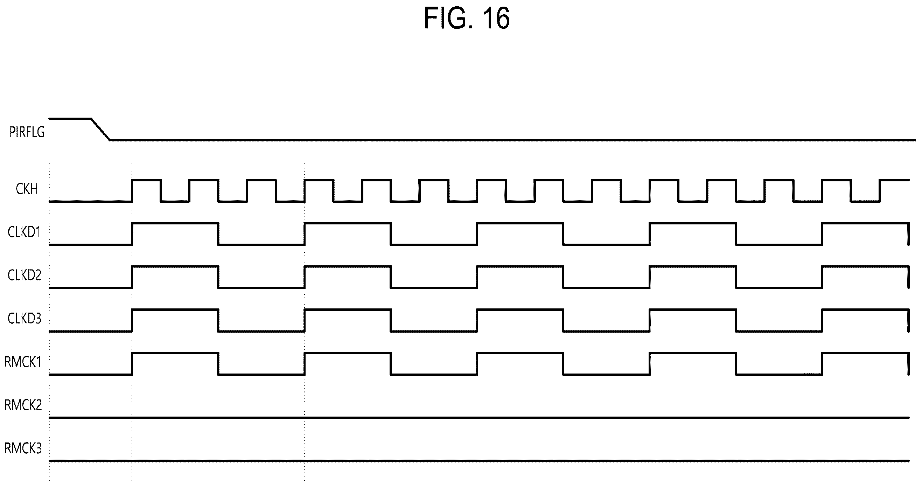

Referring to FIG. 16, the control clock generation circuit 640 outputs the first divided clock signal CKD1 as the first control clock signal RMCK1 when in a normal read mode, that is, when the plane interleave read mode setting signal PIRFLG is deactivated, and the second control clock signal RMCK2 and the third control clock signal RMCK3 are fixed to a low level. Thus, an embodiment of the present disclosure can prevent unnecessary power consumption by fixing the second control clock signal RMCK2 and the third control clock signal RMCK3, which are independent of the plane interleave read mode, to a low level when it is not in the plane interleave read mode.

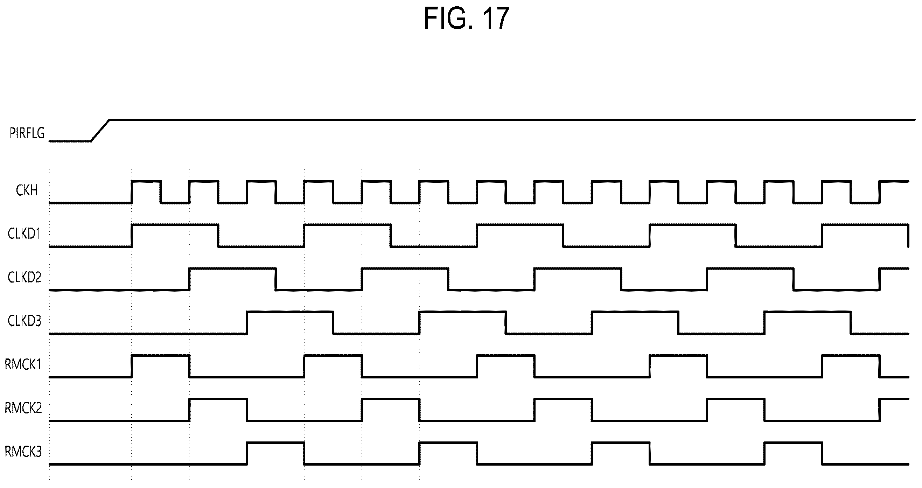

Referring to FIG. 17, the control clock generation circuit 640, when the plane interleave read mode setting signal PIRFLG is activated, may output a signal having a high-level interval corresponding to a phase difference between the first divided clock signal CKD1 and the second divided clock signal CKD2 as the first control clock signal RMCK1, output a signal having a high-level interval corresponding to a phase difference between the second divided clock signal CKD2 and the third divided clock signal CKD3 as the second control clock signal RMCK2, and output a signal having a high-level interval corresponding to a phase difference between the third divided clock signal CKD3 and the first divided clock signal CKD1 as the third control clock signal RMCK3. When the plane interleave read mode setting signal PIRFLG is deactivated, the first control clock signal RMCK1 has a high-level interval corresponding to 1.5 cycles of the clock signal CKH. When the plane interleave read mode setting signal PIRFLG is activated, the first control clock signal RMCK1 has a high-level interval corresponding to 1 cycle of the clock signal CKH.

Referring to FIGS. 15, 18, and 19, the plurality of control signal generation units 650 to 670 may generate the plurality of preliminary wordline control signals RWLEN<3:1> and the plurality of load control signals RLDEN<3:1> by combining delayed signals of each of the plurality of control clock signals RMCK<3:1>.

The first control signal generation unit 650 may receive the first control clock signal RMCK1 and the timing adjustment signal TT<2:1> and output the first preliminary wordline control signal RWLEN1 and the first load control signal RLDEN1.

The first control signal generation unit 650 may include first to third delay circuits 651 to 653 and first and second logic gates 654, 655. The first delay circuit 651 may delay the first control clock signal RMCK1 by a set amount of time to generate a first delay signal DEL1. The second delay circuit 652 may delay the first delay signal DEL1 by a time adjusted by a timing adjustment signal TT1 to generate a second delay signal DEL2. The third delay circuit 653 may delay the second delay signal DEL2 by a time adjusted by a timing adjustment signal TT2 to generate a third delay signal DEL3. The first logic gate 654 may output a result from performing an AND operation on the second delay signal DEL2 and the third delay signal DEL3 as the first preliminary wordline control signal RWLEN1. The second logic gate 655 may output a result from performing an AND operation on the first delay signal DEL1 and the third delay signal DEL3 as the first load control signal RLDEN1.

The second control signal generation unit 660 may receive the second control clock signal RMCK2 and the timing adjustment signal TT<2:1> and output the second preliminary wordline control signal RWLEN2 and the second load control signal RLDEN2. The second control signal generation unit 660 may have the same configuration as the first control signal generation unit 650.

The third control signal generation unit 670 may receive the third control clock signal RMCK3 and the timing adjustment signal TT<2:1> and output the third preliminary wordline control signal RWLEN3 and the third load control signal RLDEN3. The third control signal generation unit 670 may have the same configuration as the first control signal generation unit 650.

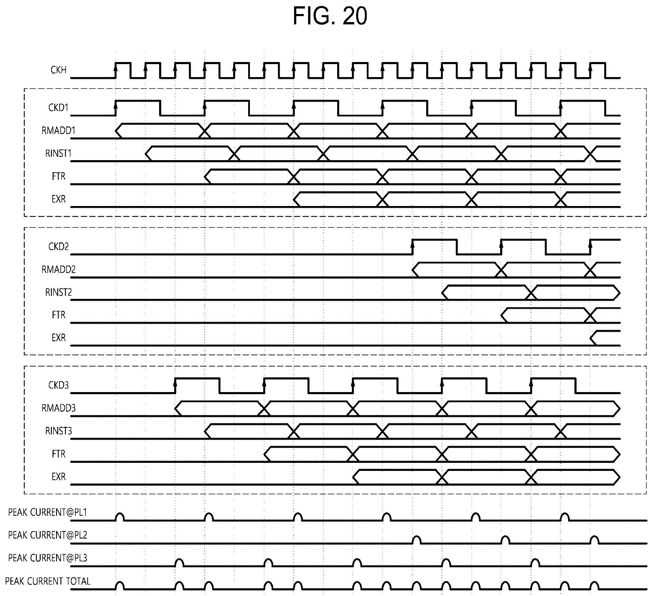

FIG. 20 is a diagram illustrating an operation of the memory apparatus 100 according to an embodiment of the present disclosure.

Hereinafter, with reference to FIGS. 6 to 20, a plane interleave read operation of the memory apparatus 100 will be described. For ease of description, the plurality of planes PL1 to PLn is three (n=3). When a plane interleave read mode is activated, a read operation for the first to third planes PL1 to PL3 may be performed in a preset order. An embodiment of the present disclosure will be described in which, when the plane interleave read mode is activated, the read operation is set to be performed in the order of the first plane PL1, the third plane PL3, and the second plane PL2.

First, as described with reference to FIG. 8, as a read command for the first plane PL1 is input, the first active signal ACT-PL1 may be activated, and the first divided clock signal CKD1 may be activated accordingly.

The micro control unit 300-1 coupled with the first plane PL1 provides the instruction memory 600 with the address signal RMADD1 having different values based on each of rising edges of the first divided clock signal CKD1.

The instruction memory 600 sequentially generates differently valued instruction code RINST1 according to a differently valued address signal RMADD1. The differently valued instruction code RINST1 may be generated at one cycle time interval of the clock signal CKH relative to an input timing of the address signal RMADD1.

The differently valued instruction code RINST1 is stored in the fetch register FTR at one cycle time interval of the first divided clock signal CKD1 relative to an input timing of the address signal RMADD1.

The differently valued instruction code RINST1 stored in the fetch register FTR may be decoded by the decoder DEC.

An output of the decoder DEC is stored in the execution register EXR at one cycle time interval of the first divided clock signal CKD1 relative to a timing at which the instruction code RINST1 of different value is input to the fetch register FTR and simultaneously provided to the peripheral circuit PER1.

According to an output of the execution register EXR, an operation of the peripheral circuit PER1 is controlled and a read operation to the first plane PL1 is performed accordingly.

Subsequently, as a read command for the third plane PL3 is input, the third active signal ACT-PL3 may be activated, and the third divided clock signal CKD3 may be activated accordingly.

The micro control unit 300-3 coupled with the third plane PL3 provides the instruction memory 600 with the address signal RMADD3 having different values based on each of rising edges of the third divided clock signal CKD3.

The instruction memory 600 sequentially generates differently valued instruction code RINST3 according to differently valued address signal RMADD3. The differently valued instruction code RINST3 may be generated at one cycle time interval of the clock signal CKH relative to an input timing of the address signal RMADD3.

The differently valued instruction code RINST3 is stored in the fetch register FTR at one cycle time interval of the third divided clock signal CKD3 relative to an input timing of the address signal RMADD3.

The different valued instruction code RINST3 stored in the fetch register FTR may be decoded by the decoder DEC.

An output of the decoder DEC is stored in the execution register EXR at one cycle time interval of the third divided clock signal CKD3 relative to a timing at which the instruction code RINST3 of different value is input to the fetch register FTR and simultaneously provided to the peripheral circuit PER3.

According to an output of the execution register EXR, an operation of the peripheral circuit PER3 is controlled, and a read operation for the third plane PL3 is performed accordingly.

As a read command for the second plane PL2 is input, the second active signal ACT-PL2 is activated, and the second divided clock signal CKD2 may be activated accordingly.

The micro control unit 300-2 coupled with the second plane PL2 provides the instruction memory 600 with the address signal RMADD2 having different values based on each of rising edges of the second divided clock signal CKD2.

The instruction memory 600 sequentially generates differently valued instruction code RINST2 according to the differently valued address signal RMADD2. The differently valued instruction code RINST2 may be generated at one cycle time interval of the clock signal CKH relative to an input timing of the address signal RMADD2.

The differently valued instruction code RINST2 is stored in the fetch register FTR at one cycle time interval of the second divided clock signal CKD2 relative to an input timing of the address signal RMADD2.

The different valued instruction code RINST2 stored in the fetch register FTR may be decoded by the decoder DEC.

An output of the decoder DEC is stored in the execution register EXR at one cycle time interval of the second divided clock signal CKD2 relative to a timing at which the instruction code RINST2 of different value is input to the fetch register FTR and simultaneously provided to the peripheral circuit PER2.

According to an output of the execution register EXR, an operation of the peripheral circuit PER2 is controlled and a read operation to the second plane PL2 is performed accordingly, so that the plane interleave read operation may be completed.

The embodiment of the present disclosure described above allows the plurality of micro control units MCU1 to MCUn coupled with each of the plurality of planes PL1 to PLn to share one instruction memory 600, which can reduce circuit area compared to using a plurality of instruction memories, facilitate circuit design by simplifying signal line wiring, and increase a layout margin.

Because the plurality of micro control units MCU1 to MCUn operate based on a divided clock signal (one of CKD<n:1>) of different phase, the plurality of micro control units MCU1 to MCUn can freely access the instruction memory 600 to perform a plane interleave read operation without overlapping the timing of accessing the instruction memory 600.

In addition, because there is no overlap in the timing of the plurality of micro control units MCU1 to MCUn accessing the instruction memory 600, there is no overlap in the peak current per plane, which can reduce current consumption and increase the reliability of a read operation.

Concepts are disclosed in conjunction with examples and embodiments of the present disclosure. Those skilled in the art will understand that various modifications, additions, combinations, and substitutions are possible without departing from the scope and technical concepts of the present disclosure. The embodiments disclosed in the present disclosure should be considered from an illustrative standpoint and not a restrictive standpoint. Therefore, the scope of the present disclosure is not limited to the provided descriptions. All changes within the meaning and range of equivalency of the claims are included within their scope. Furthermore, the embodiments may be combined to form additional embodiments.

## Claims

1. A memory apparatus comprising:
an instruction memory configured to output a plurality of instruction codes at a predetermined time interval in accordance with a plurality of address signals and a plurality of divided clock signals; and
a plurality of micro control units coupled to each of a plurality of memory regions, configured to provide each of the plurality of address signals to the instruction memory in accordance with each of the plurality of divided clock signals, and configured to perform operations in accordance with corresponding instruction codes among the plurality of instruction codes.

2. The memory apparatus of claim 1, further comprising a divider circuit configured to divide a clock signal to generate the plurality of divided clock signals.

3. The memory apparatus of claim 2, wherein the divider circuit is configured to generate the plurality of divided clock signals having a predetermined phase difference upon activation of a plane interleave read mode setting signal, and generate the plurality of divided clock signals having a same phase upon deactivation of the plane interleave read mode setting signal.

4. The memory apparatus of claim 2, wherein the divider circuit comprises:
a multi-phase signal generator configured to receive the clock signal to output multi-phase signals;
a pre-divided clock generator configured to receive the multi-phase signals and the clock signal to output a plurality of pre-divided clock signals;
an activation control circuit configured to selectively activate the pre-divided clock generator in response to a reset signal and a plurality of active signals corresponding to each of the plurality of memory regions; and
a plurality of multiplexers configured to selectively output the plurality of pre-divided clock signals as the plurality of divided clock signals in accordance with a plane interleave read mode setting signal.

5. The memory apparatus of claim 2, further comprising an oscillator configured to generate the clock signal having a frequency corresponding to a number of the plurality of micro control units.

6. The memory apparatus of claim 1, wherein the instruction memory comprises:
a memory core configured to output instruction data corresponding to an integrated address signal, among stored instruction data, when a wordline enable signal is activated;
an output control circuit configured to receive a plurality of preliminary wordline control signals and the plurality of address signals to output the integrated address signal and the wordline enable signal;
a command output circuit configured to receive a plurality of load control signals and the instruction data to output the plurality of instruction codes; and
a control signal generation circuit configured to receive the plurality of divided clock signals and a plane interleave read mode setting signal to output the plurality of preliminary wordline control signals and the plurality of load control signals.

7. The memory apparatus of claim 6, wherein the memory core comprises:
a memory cell array including memory cells coupled with a plurality of wordlines and a plurality of bitlines;
an address decoder configured to output a result of decoding the integrated address signal;
a wordline driver configured to activate a wordline among the plurality of wordlines corresponding to an output of the address decoder when the wordline enable signal is activated;
a bitline driver coupled between the plurality of bitlines and a global line, and configured to transmit a signal of a bitline among the plurality of bit lines corresponding to an output of the address decoder to the global line; and
a sense amplifier array configured to amplify a result of comparing the signal transmitted to the global line with a reference signal to output the amplified result as the instruction data.

8. The memory apparatus of claim 6, wherein the output control circuit comprises:
a plurality of buffer arrays configured to output a corresponding address signal of the plurality of address signals as the integrated address signal when one of the plurality of preliminary wordline control signals is activated; and
at least one logic gate configured to activate the wordline enable signal when any of the plurality of preliminary wordline control signals is activated.

9. The memory apparatus of claim 6, wherein the command output circuit comprises:
a plurality of buffer arrays configured to invert and output the instruction data when one of the plurality of load control signals is activated; and
a plurality of latch arrays configured to latch output of the plurality of buffer arrays to output it as the plurality of instruction codes.

10. The memory apparatus of claim 6, wherein the control signal generation circuit comprises:
a control clock generation circuit configured to receive the plurality of divided clock signals and the plane interleave read mode setting signal to output a plurality of control clock signals; and
a plurality of control signal generation logics configured to generate the plurality of preliminary wordline control signals and the plurality of load control signals by combining delayed signals of each of the plurality of control clock signals.

11. The memory apparatus of claim 10, wherein the control clock generation circuit is configured to output a first divided clock signal among the plurality of divided clock signals as a first control clock signal among the plurality of control clock signals upon deactivation of the plane interleave read mode setting signal, and fix remaining control clock signals except the first control clock signal to a low level.

12. A memory apparatus comprising:
a plurality of planes;
an input/output pad circuit including a plurality of pads;
a data input/output circuit coupled with the input/output pad circuit;
an instruction memory configured to output a plurality of instruction codes at a predetermined time interval in accordance with a plurality of address signals and a plurality of divided clock signals; and
a plurality of memory operation control related circuits configured to be in common connection with the data input/output circuit, be in one-to-one connection with the plurality of planes, provide each of the plurality of address signals to the instruction memory in accordance with each of the plurality of divided clock signals, and perform operations in accordance with corresponding instruction codes among the plurality of instruction codes.

13. The memory apparatus of claim 12, wherein the instruction memory comprises:
a memory core configured to output instruction data corresponding to an integrated address signal, among stored instruction data, when a wordline enable signal is activated;
an output control circuit configured to receive a plurality of preliminary wordline control signals and the plurality of address signals to output the integrated address signal and the wordline enable signal;
a command output circuit configured to receive a plurality of load control signals and the instruction data to output the plurality of instruction codes; and
a control signal generation circuit configured to receive the plurality of divided clock signals and a plane interleave read mode setting signal to output the plurality of preliminary wordline control signals and the plurality of load control signals.

14. The memory apparatus of claim 12, wherein the memory core comprises:
a memory cell array including memory cells coupled with a plurality of wordlines and a plurality of bitlines;
an address decoder configured to output a result of decoding the integrated address signal;
a wordline driver configured to activate a wordline among the plurality of wordlines corresponding to an output of the address decoder when the wordline enable signal is activated;
a bitline driver coupled between the plurality of bitlines and a global line, and configured to transmit a signal of a bitline among the plurality of bit lines corresponding to an output of the address decoder to the global line; and
a sense amplifier array configured to amplify a result of comparing the signal transmitted to the global line with a reference signal to output the amplified result as the instruction data.

15. The memory apparatus of claim 13, wherein the output control circuit comprises:
a plurality of buffer arrays configured to output a corresponding address signal of the plurality of address signals as the integrated address signal when one of the plurality of preliminary wordline control signals is activated; and
at least one logic gate configured to activate the wordline enable signal when any of the plurality of preliminary wordline control signals is activated.

16. The memory apparatus of claim 13, wherein the command output circuit comprises:
a plurality of buffer arrays configured to invert and output the instruction data when one of the plurality of load control signals is activated; and
a plurality of latch arrays configured to latch output of the plurality of buffer arrays to output it as the plurality of instruction codes.

17. The memory apparatus of claim 13, wherein the control signal generation circuit comprises:
a control clock generation circuit configured to receive the plurality of divided clock signals and the plane interleave read mode setting signal to output a plurality of control clock signals; and
a plurality of control signal generation logics configured to generate the plurality of preliminary wordline control signals and the plurality of load control signals by combining delayed signals of each of the plurality of control clock signals.

18. The memory apparatus of claim 17, wherein the control clock generation circuit is configured to output a first divided clock signal among the plurality of divided clock signals as a first control clock signal among the plurality of control clock signals upon deactivation of the plane interleave read mode setting signal, and fix remaining control clock signals except the first control clock signal to a low level.

19. The memory apparatus of claim 12, wherein the plurality of memory operation control related circuits are configured to control a program operation and a read operation of the plurality of planes.

20. The memory apparatus of claim 12, wherein each of the plurality of memory operation control related circuits comprises:
a peripheral circuit configured to control a program operation and a read operation of a corresponding plane among the plurality of planes; and
a micro control unit configured to provide each of the plurality of address signals to the instruction memory in accordance with each of the plurality of divided clock signals, and configured to control an operation of the peripheral circuit in accordance with a result of decoding an instruction code corresponding to the peripheral circuit.

21. The memory apparatus of claim 12, further comprising a divider circuit configured to divide a clock signal to generate the plurality of divided clock signals.

22. The memory apparatus of claim 21, wherein the divider circuit is configured to generate the plurality of divided clock signals having a predetermined phase difference upon activation of a plane interleave read mode setting signal, and generate the plurality of divided clock signals having a same phase upon deactivation of the plane interleave read mode setting signal.

23. The memory apparatus of claim 21, wherein the divider circuit comprises:
a multi-phase signal generator configured to receive the clock signal to output multi-phase signals;
a pre-divided clock generator configured to receive the multi-phase signals and the clock signal to output a plurality of pre-divided clock signals;
an activation control circuit configured to selectively activate the pre-divided clock generator in response to a reset signal and a plurality of active signals corresponding to each of the plurality of memory regions; and
a plurality of multiplexers configured to selectively output the plurality of pre-divided clock signals as the plurality of divided clock signals in accordance with a plane interleave read mode setting signal.

24. The memory apparatus of claim 21, further comprising an oscillator configured to generate the clock signal having a frequency corresponding to a number of the plurality of memory operation control related circuits.
